# EUROPÄISCHE PATENTSCHRIFT

(11) **EP 1 266 550 B1**
(45) Veröffentlichungstag und Bekanntmachung des Hinweises auf die Patenterteilung: **24.01.2007**
(21) Anmeldenummer: 01931368.3
(22) Anmeldetag: 15.03.2001
(51) Int. Cl.: H05K 13/00

(54) **VORRICHTUNG ZUM TRANSPORT VON LEITERPLATTEN**
DEVICE FOR CONVEYING PRINTED BOARDS
DISPOSITIF DE TRANSPORT DE PLAQUETTES DE CIRCUITS IMPRIMES

(30) Priorität: 22.03.2000 DE 10014199
(43) Veröffentlichungstag der Anmeldung: 18.12.2002
(73) Patentinhaber: SIEMENS AKTIENGESELLSCHAFT, 80333 München (DE)
(72) Erfinder: BARNOWSKI, Frank, 81371 München (DE)
(74) Vertreter: Berg, Peter
(86) Internationale Anmeldenummer: PCT/DE2001/001007
(87) Internationale Veröffentlichungsnummer: WO 2001/072101

(56) Entgegenhaltungen:
- EP-A- 0 491 539
- US-A- 5 985 029

## Beschreibung

Die vorliegende Erfindung betrifft eine Vorrichtung zum Transport von Leiterplatten, insbesondere in Bestückautomaten.

In Bestückautomaten werden Substrate oder Leiterplatten, die mit Halbleiterchips oder Bauelementen bestückt werden, längs einer in der Regel geradlinigen Transportstrecke transportiert. Während des Bestückens wird die Leiterplatte durch Festklemmen fixiert. Der Transport erfolgt mittels Transportriemen, die über geeignete Räder oder Rollen angetrieben werden. Das Substrat oder die Leiterplatte liegt nur mit einem schmalen seitlichen Streifen auf dem Transportriemen auf. Das Substrat oder die Leiterplatte wird nach unten zu einem Grund- oder Trägerelement der Transportstrecke hin eingeklemmt. Die Transportstrecke ist in einzelne Segmente unterteilt, die in der Transportrichtung aufeinander folgen. Jedes Segment besitzt einen angetriebenen Transportriemen und eine Klemmvorrichtung für die Leiterplatten.

Aus dem Dokument US-A-5 985 029 ist eine Vorrichtung zum Transport von Leiterplatten bekannt, welche ein Trägerelement und beidseitige Transportwangen mit festen Rollen für Transportriemen aufweist. Bewegliche Platten drücken den Riemen und Leiterplatten hoch bis zu den Klemmleisten.

Aufgabe der vorliegenden Erfindung ist es, eine Vorrichtung zum Transport von Leiterplatten, insbesondere für Bestückautomaten, anzugeben, bei der der konstruktive Aufwand gegenüber herkömmlichen Transportvorrichtungen deutlich verringert ist.

Diese Aufgabe wird mit der Vorrichtung mit den Merkmalen des Anspruches 1 gelöst. Ausgestaltungen ergeben sich aus den abhängigen Ansprüchen.

Bei der erfindungsgemäßen Vorrichtung wird die Transportstrecke durch ein Grund- und Trägerelement gebildet, auf oder in dem mindestens zwei Segmente, vorzugsweise eine Mehrzahl von Segmenten, angeordnet sind, die jeweils einen Abschnitt der Transportstrecke bilden. In jedem Segment ist beidseitig in Bezug auf die Transportrichtung je eine Transportwange vorhanden, die einen seitlichen Abschluss der Transportvorrichtung bildet. In jedem Segment ist ein über Rollen oder Räder angetriebener Transportriemen auf der der gegenüberliegenden Transportwange zugewandten Seite der Transportwangen angebracht. Diese Rollen mit dem Transportriemen befinden sich auf beweglichen Platten, die auf den Innenseiten der Transportwangen senkrecht zur Transportrichtung bewegt werden können. An den oberen Rändern der Transportwangen befinden sich auf der Innenseite in Längsrichtung angebrachte Klemmleisten, die die beweglichen Platten derart überragen, dass eine Leiterplatte beim Anheben der beweglichen Platten beidseitig mit ihrem Rand zwischen dem Transportriemen und der Klemmleiste der Transportwange eingeklemmt wird. Die Transportwangen lassen sich quer zur Transportrichtung verstellen, so dass die Vorrichtung an unterschiedliche Breiten der zum Transport vorgesehenen Leiterplatten angepasst werden kann.

Es folgt eine genauere Beschreibung der erfindungsgemäßen Vorrichtung anhand der beigefügten Figuren 1 bis 3, die ein bevorzugtes Ausführungsbeispiel darstellen.
- Figur 1: Zeigt einen Ausschnitt aus der erfindungsgemäßen Transportstrecke in einer schrägen Aufsicht.
- Figur 2: Zeigt die Anordnung der beweglichen Platten an der Transportwange im Querschnitt.
- Figur 3: Zeigt die Anordnung der beweglichen Platte mit dem Antrieb des Transportriemens an der Transportwange in einer schrägen Ansicht.

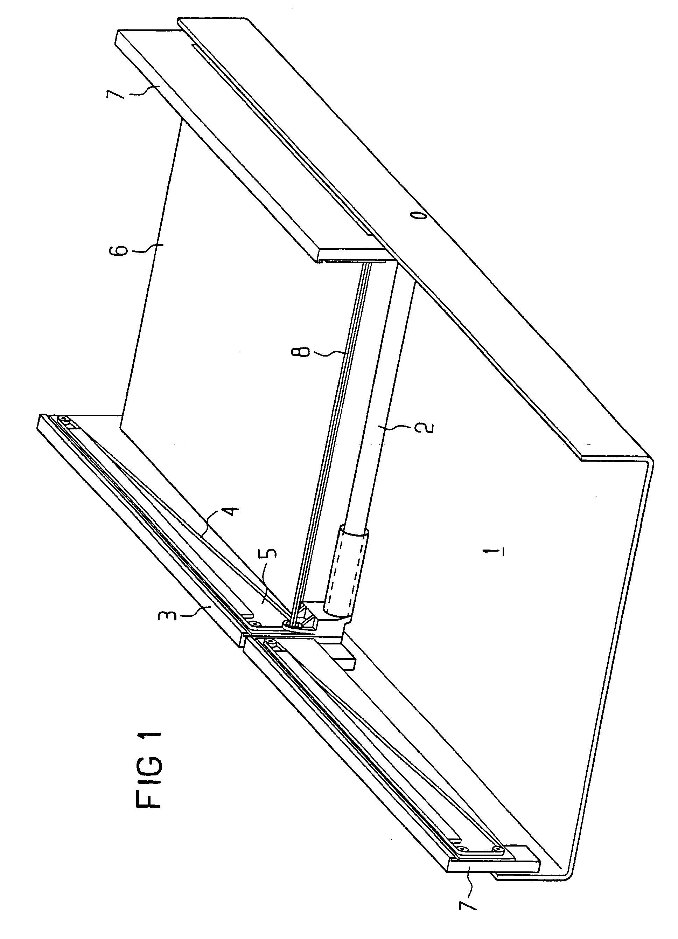

In Figur 1 ist ein Ausschnitt aus der Transportstrecke dargestellt, deren Basis durch ein Grund- und Trägerelement 1 gebildet wird. Dieses Grund- und Trägerelement 1 besitzt in diesem Beispiel ein U-förmiges Querprofil, das durch einen im wesentlichen ebenen Boden und zwei daran angesetzte senkrechte Seitenteile gebildet ist. Auf den Innenseiten der Seitenteile sind die Transportwangen 7 angebracht, die in diesem Ausführungsbeispiel jeweils in der Transportrichtung eine einem jeweiligen Segment entsprechende Länge aufweisen. Möglich ist auch eine Ausführungsform, bei der sich beidseitig je eine allen Segmenten oder zumindest einem Teil der Segmente gemeinsam zugehörige Transportwange befindet. An den Innenseiten, das heißt den der gegenüberliegenden Transportwange beziehungsweise einer zu transportierenden Leiterplatte zugewandten Seiten, sind in jedem Segment bewegliche Platten 5 angebracht, an denen ebenfalls zur Innenseite hin die Transportriemen 4 angeordnet sind, die über Rollen oder Räder angetrieben werden. Diese Rollen oder Räder sind so auf der beweglichen Platte 5 angebracht, dass ein Anteil des Transportriemens 4 am oberen Rand der beweglichen Platte im wesentlichen horizontal verläuft. Die jeweils nach innen gewandten oberen Ränder der Transportwangen 7 sind mit Klemmleisten 3 versehen, die längs der Transportrichtung ausgerichtet sind und die beweglichen Platten 5 so weit überragen, dass zwischen den Klemmleisten 3 und dem jeweils horizontalen oberen Anteil des Transportriemens ein gleichmäßiger Zwischenraum gebildet wird.

Die beweglichen Platten 5 lassen sich durch eine angebrachte Hubvorrichtung in der vertikalen Richtung anheben, so dass dieser Zwischenraum zwischen der Klemmleiste 3 und den Transportriemen 4 so weit verringert wird, dass er der Dicke eines Randes einer zu transportierenden Leiterplatte entspricht. Als Hubvorrichtung ist vorzugsweise ein Hubtisch 6 vorgesehen, der auch zur Abstützung der Leiterplatten dienen kann. Die Ränder der Leiterplatten können so unter den Klemmleisten 3, also in Richtung nach oben, eingeklemmt werden, dass sie arretiert werden und eine Bestückung vorgenommen werden kann.

Der Antrieb der Transportriemen erfolgt vorzugsweise jeweils für beide Transportwangen eines Segmentes gleichzeitig, zum Beispiel über die in Figur 1 eingezeichnete Welle 8 (vorzugsweise zum Beispiel eine Sechskantwelle), an deren Enden jeweils ein Rad des Riemenantriebes aufsitzt. Es ist unerheblich, ob die Welle 8 konzentrisch zu dem Antriebsrad angeordnet ist und als Antriebsachse vorgesehen ist oder ob die Welle 8 als Zahnwelle an der Peripherie eines Antriebszahnrades angreift. Die Welle 8 ist mit einem geeigneten Antrieb versehen, der in den Figuren nicht dargestellt ist. Der Antrieb der Welle 8 kann zum Beispiel mittels eines in jedem Segment vorhandenen Antriebsmotors erfolgen; oder es ist eine geeignete Transmission angebracht, die an einen zentralen Antrieb angekuppelt ist oder angekuppelt werden kann. Die quer zur Transportrichtung angeordnete Linearführung 2, die in Figur 1 nicht mit allen Einzelheiten dargestellt ist, um die Abbildung nicht zu unübersichtlich werden zu lassen, dient dazu, die Transportwangen 7 quer zur Transportrichtung zu verschieben, um den Abstand dazwischen entsprechend der Größe der zu transportierenden Leiterplatten verändern zu können.

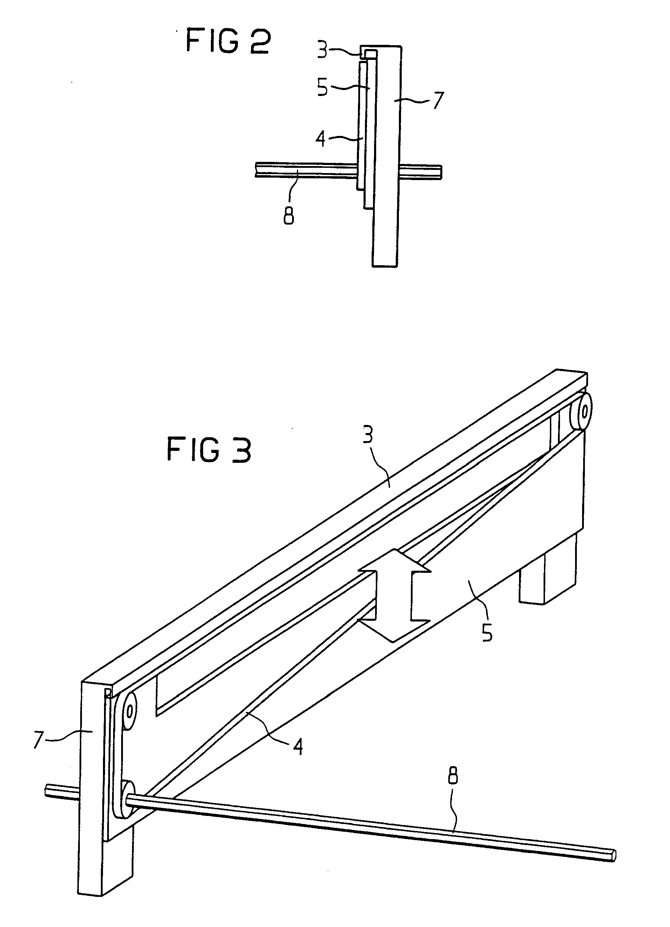

In Figur 2 ist die Anordnung der beweglichen Platten 5 an den Transportwangen 7 im Querschnitt schematisch dargestellt. In Figur 2 ist erkennbar, dass die Klemmleiste 3 auf der Innenseite der Transportwange 7 vorzugsweise die bewegliche Platte 5 jeweils so weit überragt, dass ein ausreichend geringer Abstand zwischen dem Transportriemen 4 und der Klemmleiste 3 durch ein vertikales Verschieben der beweglichen Platte 5 nach oben hergestellt werden kann. Es wird anhand der Figur 2 auch deutlich, dass zusammen mit der Platte 5 auch der Antrieb, hier durch die Welle 8 dargestellt, vertikal verschoben werden muss. Da der Antrieb mit der beweglichen Platte 5 relativ zu der Transportwange 7 bewegt werden muß, sind die Welle 8 und gegebenenfalls vorhandene weitere Komponenten des Antriebs vorzugsweise schwimmend bezüglich der Transportwange 7 gelagert. Das bedeutet, dass die Antriebsaggregate zwar an den Transportwangen angeordnet sind, die Lagerung aber so vorgenommen ist, dass die Antriebsaggregate mit der beweglichen Platte 5 zusammen bewegt werden können.

Die bewegliche Platte 5 ist zum Beispiel mittels vertikal angeordneter Führungsleisten, beispielsweise ähnlich den eingezeichneten Klemmleisten, so an der jeweiligen Transportwange angebracht, dass sie an der Transportwange 7 entlang nach oben bewegt werden kann. Die dafür einsetzbaren konstruktiven Mittel sind an sich bekannt und können mit den dem einschlägigen Fachmann bekannten Maßnahmen und Vorgehensweisen realisiert werden.

Figur 3 zeigt eine schräge Ansicht einer einzelnen Transportwange mit einer darauf angebrachten beweglichen Platte 5. Der eingezeichnete Doppelpfeil zeigt an, dass die bewegliche Platte 5 relativ zu der Transportwange 7 nach oben und unten bewegt werden kann. Damit wird der Zwischenraum zwischen dem zwischen den beiden oberen Rädern horizontal verlaufenden Anteil des Transportriemens 4 und der an der Transportwange 7 angebrachten Klemmleiste 3 eingestellt. Als Transportriemen kann ein V-Riemen, Flachriemen, Zahnriemen oder Rundriemen verwendet werden, wie er an sich bekannt ist.

Die Verstellmöglichkeit der Transportwangen quer zur Transportrichtung mittels der in Figur 1 eingezeichneten Linearführung 2 kann unterschiedlich ausgestaltet sein. So kann vorgesehen sein, dass nur jeweils die Transportwangen auf einer Seite verschiebbar sind. Statt dessen können die Transportwangen auf beiden Seiten nach innen und außen verschiebbar angebracht sein. Die jeweilige Arretierung der Transportwangen kann durch einen an sich bekannten Klemmmechanismus bewirkt werden. Die Breite des Transportriemens 4 ist so gewählt, dass nur der für den Vorschub verwendbare Rand der Leiterplatte abgedeckt wird. Durch die Lagerung des Riemens auf der beweglichen Platte ist gewährleistet, dass im Gegensatz zu einer Transportvorrichtung, die die Leiterbahnen von oben auf den Transportriemen drückt, auch extrem dünne Leiterplatten nicht zwischen den Riemen und die Andruckvorrichtung eingezogen werden. Die erfindungsgemäße Vorrichtung kann eine Mehrzahl von Transportstrecken umfassen, die nebeneinander angeordnet sind und jeweils aus Segmenten der beschriebenen Art aufgebaut sind. Es kann dabei vorgesehen sein, dass die Breiten der Transportstrecken gemeinsam oder unabhängig voneinander eingestellt werden können, indem die Abstände der Transportwangen verändert werden.

## Patentansprüche

1. Vorrichtung zum Transport von Leiterplatten
mit mindestens einer Transportstrecke, die
ein Grund- und Trägerelement (1) und
eine Mehrzahl von Segmenten umfasst, die in einer vorgesehenen Transportrichtung aufeinander folgen, wobei die Segmente aufweisen
bezogen auf die Transportrichtung beidseitig eine Transportwange (7) mit Rollen, die mit einem Antrieb versehen sind und einen darüber laufenden Transportriemen (4) antreiben, und eine Vorrichtung zum Andrücken der Leiterplatten an die Transportriemen, Bei dieser Vorrichtung ist weiterhin vorgesehen,
dass jeweils auf der einer gegenüberliegend angeordneten Transportwange (7) zugewandten Seite
an oberen Rändern der Transportwangen (7) jeweils eine in der Transportrichtung ausgerichtete Klemmleiste (3) vorhanden ist,
an den Transportwangen (7) in jedem Segment eine vertikal ausgerichtete bewegliche Platte (5) angeordnet ist und
die Rollen mit dem Transportriemen jeweils an der beweglichen Platte angebracht sind,
dass jedes Segment eine Hubvorrichtung aufweist, die dafür vorgesehen ist, die beweglichen Platten (5) in Richtung zu den Klemmleisten (3) hin anzuheben, und
dass die Transportriemen (4) an den beweglichen Platten (5) und die Klemmleisten (3) an den Transportwangen (7) so angeordnet sind, dass durch Anheben der beweglichen Platten (5) zwischen den Transportriemen (4) und den Klemmleisten (3) ein Zwischenraum eingestellt werden kann, der für eine jeweilige randseitige Dicke einer für einen Transport vorgesehenen Leiterplatte bemessen ist.

2. Vorrichtung nach Anspruch 1, bei der
die Hubvorrichtung in jedem Segment vorhandene Hubtische (6) umfasst.

3. Vorrichtung nach Anspruch 1 oder 2, bei der in jedem Segment
jeweils Transportwangen (7) vorhanden sind, die in der Transportrichtung eine dem betreffenden Segment entsprechende Länge aufweisen, und
jeweils quer zur Transportstrecke eine Linearführung (2) vorhanden ist, mit der der Abstand der Transportwangen (7) des betreffenden Segmentes zueinander verändert werden kann.

4. Vorrichtung nach einem der Ansprüche 1 bis 3, bei der
der Antrieb der an den beweglichen Platten (5) angebrachten Rollen jeweils über eine quer zur Transportstrecke angeordnete Welle (8) mit einem daran angebrachten Antriebsaggregat erfolgt, wobei die Welle (8) und das Antriebsaggregat jeweils die Transportriemen (4) zweier einander gegenüberliegend angeordneter beweglicher Platten (5) antreiben und bezüglich der Transportwangen (7) schwimmend gelagert sind.

## Claims

1. Device for conveying printed boards
with at least one conveyor path, comprising
a base and carrier element (1) and
a number of segments, which follow each other in a specified direction of conveyance, the segments having
on both sides in relation to the direction of conveyance a conveyor cheek (7) with rollers, which are provided with a drive unit and drive a conveyor belt (4) running over them and a device for pressing the printed boards onto the conveyor belts, said device having further provision
on the side facing an opposite conveyor cheek (7) in each instance
for a connector block (3) to be present at the upper edges of the conveyor cheeks (7) in each instance aligned in the direction of conveyance,
for a vertically aligned movable plate (5) to be disposed on the conveyor cheeks (7) in each segment and
for the rollers to be mounted with the conveyor belt respectively on the movable plate,
each segment having a lifting device, which is provided to lift the movable plates (5) towards the connector blocks (3) and
the conveyor belts (4) being disposed on the movable plates (5) and the connector blocks (3) being disposed on the conveyor cheeks (7) such that by lifting the movable plates (5) an intermediate space can be adjusted between the conveyor belts (4) and the connector blocks (3), said space being dimensioned for a respective edge thickness of a printed board to be conveyed.

2. Device according to claim 1, wherein the lifting device comprises lifting platforms (6) present in each segment.

3. Device according to claim 1 or 2, wherein in each segment conveyor cheeks (7) are present, having a length corresponding to the relevant segment in the direction of conveyance and a linear guide (2) is provided perpendicular to the conveyor path, which can be used to change the distance between the conveyor cheeks (7) of the relevant segment in relation to each other.

4. Device according to one of claims 1 to 3, wherein the rollers mounted on the movable plates (5) are driven respectively by way of a shaft (8) disposed perpendicular to the conveyor path, with a drive unit mounted thereon, with the shaft (8) and the drive unit respectively driving the conveyor belts (4) of two movable plates (5) disposed opposite each other and being supported in a floating arrangement in relation to the conveyor cheeks (7).

## Revendications

1. Dispositif de transport de plaquettes de circuits imprimés avec au moins un chemin de transport qui comprend un élément de base et de support (1) et une pluralité de segments qui se succèdent dans un sens de transport prévu, les segments comportant, de part et d'autre par rapport au sens du transport, une paroi de transport (7) avec des galets qui sont pourvus d'un entraînement et entraînent une courroie de transport (4) qui passe au-dessus, et un dispositif pour pousser les plaquettes de circuits imprimés contre les courroies de transport, dispositif dans lequel il est en outre prévu qu'est présent respectivement un rebord de serrage (3) orienté dans le sens du transport, respectivement sur le côté tourné vers une paroi de transport (7) disposée à l'opposé, sur des bords supérieurs des parois de transport (7), qu'une plaque mobile (5) orientée verticalement est disposée sur les parois de transport (7) dans chaque segment et que les galets avec la courroie de transport sont montés respectivement sur la plaque mobile, que chaque segment comporte un dispositif de levage qui est prévu pour soulever les plaques mobiles (5) en direction des rebords de serrage (3) et en ce que les courroies de transport (4), sur les plaques mobiles (5), et les rebords de serrage (3), sur les parois de transport (7), sont disposés de manière telle qu'il est possible, en soulevant les plaques mobiles (5), d'ajuster un espace intermédiaire entre les courroies de transport (4) et les rebords de serrage (3), lequel espace est dimensionné pour une épaisseur de bord respective d'une plaquette de circuits imprimés prévue pour un transport.

2. Dispositif selon la revendication 1, dans lequel le dispositif de levage comprend des tables élévatrices (6) présentes dans chaque segment.

3. Dispositif selon la revendication 1 ou 2, dans lequel sont présentes, dans chaque segment, respectivement des parois de transport (7) qui présentent, dans le sens du transport, une longueur correspondant au segment concerné et est présent, dans chaque segment, respectivement transversalement par rapport au chemin de transport, un guidage linéaire (2) permettant de modifier la distance des parois de transport (7) du segment concerné entre elles.

4. Dispositif selon l'une des revendications 1 à 3, dans lequel l'entraînement des galets montés sur les plaques mobiles (5) se fait respectivement par l'intermédiaire d'un arbre (8) disposé transversalement par rapport au chemin de transport, avec un mécanisme d'entraînement monté dessus, l'arbre (8) et le mécanisme d'entraînement entraînant respectivement les courroies de transport (4) de deux plaques mobiles (5) disposées face à face et étant logés de manière flottante par rapport aux parois de transport (7).
